# EUROPEAN PATENT APPLICATION

(11) **EP 3 239 726 A1**
(43) Date of publication of application: **01.11.2017**
(21) Application number: 16167526.9
(22) Date of filing: 28.04.2016
(51) Int. Cl.: G01R 31/26, G01R 31/28

(54) **TESTING METHOD WITH ACTIVE HEATING AND TESTING SYSTEM**

(71) Applicant: Vincotech GmbH, 82008 Unterhaching (DE)
(72) Inventor: PÁVA, Zsolt, 2541 Lábatlan (HU); DROPPA, Imre, 8112 Zichyújfalu Ady (HU); IPACH, Gábor, 2800 Tatabánya (HU); VÁZSONYI, Márton, 2060 Bicske Endresz (HU); SZABÓ, Zsolt, 2461 Tárnok (HU); URECZKI, Zoltán, 1015 Budapest (HU); TEMESI, Ernö, 2094 Nagykovácsi (HU)
(74) Representative: Grünecker Patent- und Rechtsanwälte PartG mbB

(57) **Abstract**

The present invention provides a testing method for testing at least one semiconductor component (102) comprising a semiconductor switch (T1,T2,T3,T4) under elevated temperature conditions by means of a testing device, the method comprising the following steps: electrically connecting the semiconductor component (102) with the testing device, supplying a heating signal from the testing device to the at least one semiconductor component (102), wherein supplying the heating signal comprises applying a switching signal to the semiconductor component (102) that causes the semiconductor switch (T1,T2,T3,T4) to open and close with a pre-determined switching frequency, so that the semiconductor component (102) is at least partly heated up by switching losses caused by the semiconductor switch's switching operation, and supplying at least one test signal from the testing device to the at least one semiconductor component (102), and in response to the at least one test signal, determining at least one test result of the semiconductor component (102).

## Description

The present invention generally relates to testing methods for testing semiconductor components and to testing systems for performing such testing methods.

Semiconductor components such as power modules are used in a variety of safety critical applications, such as energy supply and traction technologies. Consequently, it is necessary to ascertain a sufficient reliability of the semiconductor component in view of its lifetime.

For assessing the lifetime of semiconductor components, it is known to perform so called active power cycling tests where a load current is supplied to randomly chosen devices under test (DUT). When a maximum target temperature is reached, the load current is switched off and the system cools down to a minimum temperature. The reaching of the minimum temperature completes the cycle and the next cycle begins by starting the load current again. This procedure is repeated until predetermined end-of-life criteria are fulfilled. Thus, power cycling tests lead to a lifetime approximation which is close to the application when performed under realistic conditions. Thermal cycling may also be used as an accelerated aging methodology for determining degradation and lifetime of semiconductor components.

On the other hand, in order to detect semiconductor components that are candidates for early failure, usually final tests are performed with all semiconductor components before delivery. Such tests often comprise operational tests under elevated temperatures. Known test systems heat up the complete semiconductor component e. g. by means of a heated plate.

However, this procedure is time consuming and necessitates heating structures inside the test equipment. Moreover, the complete semiconductor component has to be heated and cooled down after the test procedure which additionally extends the testing time. In particular for power modules where only the semiconductor switches have to be tested under elevated temperature conditions, an unacceptably long time is needed for heating and subsequently cooling the complete, comparably large module.

Consequently, there is a need to provide an improved testing method and testing system that allow a fast, efficient, and reliable testing of semiconductor components under elevated temperatures.

This object is solved by the subject matter of the independent claims. Advantageous embodiments of the present invention are the subject matter of the dependent claims.

According to the present invention, a testing method for testing at least one semiconductor component with a semiconductor switch under elevated temperature conditions by means of a testing device is provided, the method comprising the following steps:
electrically connecting the semiconductor component with the testing device,
supplying a heating signal from the testing device to the at least one semiconductor component, wherein supplying the heating signal comprises applying a switching signal to the semiconductor component that causes the semiconductor switch to open and close with a pre-determined switching frequency, so that the semiconductor component is at least partly heated up by switching losses caused by the semiconductor switch's switching operation,
supplying at least one test signal from the testing device to the at least one semiconductor component, and
in response to the at least one test signal, determining at least one test result of the semiconductor component.

The present invention is based on the idea to generate the elevated temperature for testing the dynamic parameters of the semiconductor component by causing the device under test (DUT) to heat itself (and essentially only itself without heating its environment) by means of the thermal losses of the semiconductor switch's own operation. In other words, the semiconductor switch performs a heating operation that is not necessarily part of the actual testing procedure, but only serves to reach the elevated temperature at which the semiconductor component has to be tested electrically.

In particular, the at least one semiconductor component comprises at least one semiconductor switch, wherein supplying the heating signal comprises applying a switching signal to the semiconductor component that causes the semiconductor switch to open and close with a pre-determined switching frequency. The present invention may advantageously be used for testing power modules comprising insulated gate bipolar transistors (IGBTs) as semiconductor switches. Having the advantage of joining together the bipolar conduction characteristics and the insulated gate control, IGBTs have received much attention in recent years for their energy efficient and rugged performance for a wide range of power applications. These devices are frequently employed in hard-switching applications, where the device is required to turn off high currents and voltages under inductive loading conditions. Robustness of devices used in such applications is a desirable feature, and a premium is placed on those devices having larger and larger reverse-bias safe operating area (RBSOA). Although the RBSOA boundaries of the IGBT devices do not severely limit their capabilities in most applications, the possibility for them to be operated for a short time out of these limits can give a better idea about their robustness.

The present invention is intended to be used together with an experimental characterization of high power IGBT modules under clamped and un-clamped conditions and at load currents and voltages to or beyond the RBSOA limits. The behavior at high junction temperatures is analyzed be heating the switches actively using thermal losses due to their own operation.

Advantageously, causing the switch to open and close with a high frequency, e. g. up to 1 MHz, generates enough heat that the semiconductor switch locally reaches the required temperature in a surprisingly short time, ca. 1 ms, while the heat does not spread significantly into the ceramic [e. g. direct copper bonding (DCB)] substrate or the housing of the power module. In contrast to developing heat by means of static losses that occur when a DC high current (e. g. a short circuit current, which heats up only the IGBT) is flowing, the present invention is based on the idea to use the dynamic switching losses for heating up the semiconductor switch. The switching losses are caused by the high voltage high current transitions that result from opening and closing of the switch with a high frequency. The switching losses heat up all semiconductors, IGBTs as well as diodes.

On the other hand, the static losses can be kept low, so that the semiconductor component is not unduly stressed by the testing method and the limitation of the maximum allowable current is not exceeded. This is important when using the testing method according to the present invention as a nondestructive final test for each individual semiconductor component prior to delivery.

According to an advantageous embodiment, the switching signal comprises a train of voltage pulses that is applied as a gate-emitter voltage (Vge) to the IGBT. For instance, the switching signal may comprise between 500 to 1000 pulses with a duration of 0.5 to 2 µs. Any other suitable values may of course be chosen, depending on the switching losses and resulting heating of the respective semiconductor switch. Moreover, the collector-emitter voltage (Vce) may be in a range between 500 V and 900 V, preferably amount to 700 V.

Advantageously, the heating step is integrated into standard testing procedures that require a heating of the DUT to over 100 °C. Accordingly, the heating signal is applied until a predetermined temperature of more than 100 °C is reached at the semiconductor component.

In order to reach the predetermined temperature, either a fixed amount of the heat generating semiconductor operations is performed according to previous experimental calibration, or the testing method itself additionally comprises the step of monitoring the temperature at the semiconductor component. The latter variant has the advantage that the testing is easily adapted to different semiconductor components without much loss of time.

According to an exemplary embodiment of the present invention, the step of determining at least one test result of the semiconductor component is performed while the semiconductor component is at elevated temperature. This allows monitoring the semiconductor component's characteristics under the influence of heat. Moreover, according to the present invention at least one defined cooling step, preferably to ambient temperature, may be performed after the step of heating up the semiconductor component. The testing of the semiconductor component may comprise a further measurement step in the cooled down state of the semiconductor component.

The present invention further relates to a testing system for testing semiconductor components under elevated temperature conditions. According to an exemplary embodiment, the testing system comprises a testing device that is electrically connected to the semiconductor component during the test.

The testing system further comprises a control means which is operable to supply a heating signal from the testing device to the at least one semiconductor component, wherein supplying the heating signal comprises applying a switching signal to the semiconductor component that causes the semiconductor switch to open and close with a pre-determined switching frequency, so that the semiconductor component is at least partly heated up by switching losses caused by the semiconductor switch's switching operation.

A measurement unit is provided which is operable to supply at least one test signal from the testing device to the at least one semiconductor component and, in response to the at least one test signal, to determine at least one test result of the semiconductor component.

According to an advantageous embodiment of the present invention, the testing system comprises a high voltage power supply circuit that is coupled with an input connector for supplying an input power to the semiconductor component. For instance for testing power modules, the standard test routines in the intended electronic environment of the power module can be performed.

In order to control semiconductor switches for performing a heating operation as well as for performing test routines on at least one semiconductor switch being part of the semiconductor component, the testing system further comprises at least one driver unit for driving the at least one semiconductor switch.

In order to protect the semiconductor component against the effects of DC overcurrent situations that may occur during the test routine, the testing system further comprises at least one DC current sensing unit for monitoring an input current that is applied to the semiconductor component, wherein the testing system further comprises a current limiter that is operable to limit the input current if the current sensing unit indicates that the input current exceeds a predefined threshold.

For presenting the electric environment needed for the testing routine, the testing system may advantageously further comprise a switchable load inductor circuit that can selectively be connected to an output connector that can be coupled to output terminals of the semiconductor component.

According to an exemplary embodiment of the present invention, the testing system is configured to test a three-level semiconductor component with a positive power input terminal, a negative power input terminal and a neutral power input terminal, and at least one output terminal. The testing system advantageously comprises a positive high voltage power supply unit for applying a positive DC voltage between the positive power input terminal and the neutral power input terminal, and a negative high voltage power supply unit for applying a negative DC voltage between the negative power input terminal and the neutral power input terminal, a first capacitor being connected in parallel to the positive high voltage power supply unit, and a second capacitor being connected in parallel to the negative high voltage power supply unit, wherein a first discharge circuit is coupled in parallel to the first capacitor and a second discharge circuit is coupled in parallel to the second capacitor, a load inductor that is selectively connected between the output terminal and either the positive power input terminal, the negative power input terminal or the neutral power input terminal, at least one gate driver that is connectable to at least one gate of a semiconductor switch comprised in the semiconductor component, wherein said gate driver is operable to provide a switching signal to the semiconductor component that causes the semiconductor switch to open and close with a pre-determined switching frequency.

In order to ensure that the power module is not damaged by any occurring overcurrents, a first current limiter may be provided that is connected in series between the positive high voltage power supply unit and the positive power input terminal for limiting a first input current flowing into the positive power input terminal in response to a first current sensor that is operable to monitor the first input current, and a second current limiter that is connected in series between the negative high voltage power supply unit and the negative power input terminal for limiting a second input current flowing into the negative power input terminal in response to a second current sensor that is operable to monitor the second input current.

The experimental characterization thus can be performed by means of a non-destructive experimental test set-up where IGBT modules are switched in presence of a protection circuit that is able to prevent a device failure at the occurrence of unstable behaviors.

The accompanying drawings are incorporated into the specification and form a part of the specification to illustrate several embodiments of the present invention. These drawings, together with the description serve to explain the principles of the invention. The drawings are merely for the purpose of illustrating the preferred and alternative examples of how the invention can be made and used, and are not to be construed as limiting the invention to only the illustrated and described embodiments. Furthermore, several aspects of the embodiments may form-individually or in different combinations-solutions according to the present invention. The following described embodiments thus can be considered either alone or in an arbitrary combination thereof. Further features and advantages will become apparent from the following more particular description of the various embodiments of the invention, as illustrated in the accompanying drawings, in which like references refer to like elements, and wherein:
- **FIG. 1a**: is a time diagram of the currents and voltages at an IGBT as an exemplary device under test;
- **FIG. 1b**: is a detail of FIG. 1 a;
- **FIG. 2**: is a table of simulated temperatures reached after the heating of an IGBT;
- **FIG. 3**: is a table of a simulated thermal resistance of an IGBT;
- **FIG. 4**: is a simulated time diagram of the voltage across an IGBT when switching same on;
- **FIG. 5**: is a simulated time diagram of the temperature rises of an IGBT;
- **FIG. 6**: is a simulated time diagram of the device power losses of an IGBT;
- **FIG. 7**: is a simulated time diagram of the junction temperature of an IGBT;
- **FIG. 8**: is a schematic block diagram of a testing system for testing a power module;
- **FIG. 9**: is schematic representation of the gate-emitter voltage, the collector-emitter voltage, and the collector current of an IGBT during a two-pulse test routine.

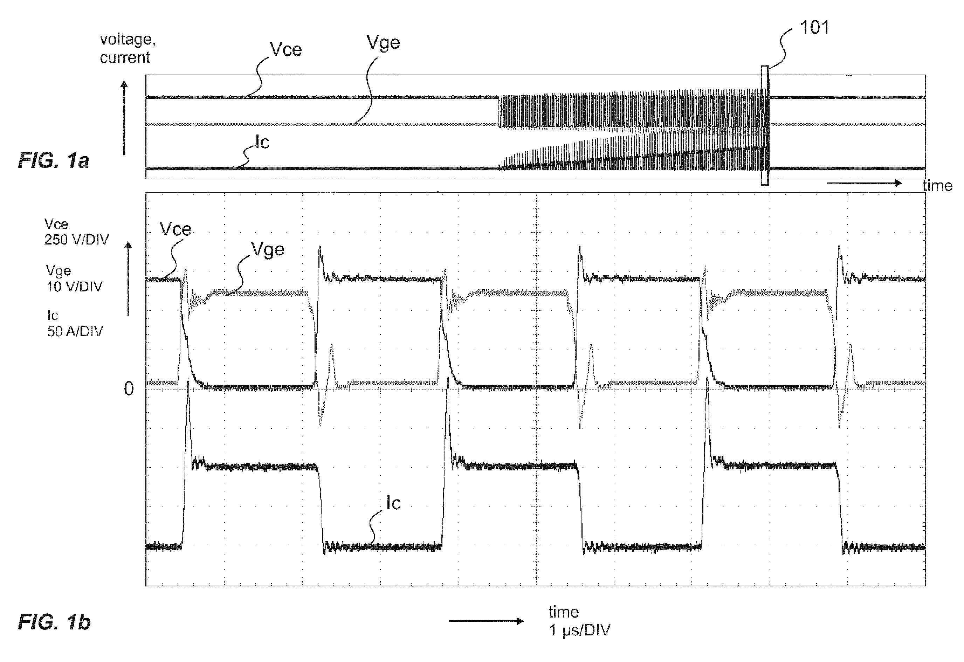

The present invention will now be explained in more detail with reference to the Figures. Referring to Figure 1, the time diagrams for the voltages and the current when heating an insulated gate bipolar transistor (IGBT) are illustrated. The IGBT may for instance be assembled on a ceramic substrate, such as a direct copper bonding (DCB) substrate.

Fig. 1 a shows a time diagram of the collector-emitter voltage (Vce), the gate-emitter voltage (Vge) and the collector current (Ic) of an IGBT under test. Fig. 1b shows the area 101 of Fig. 1a enlarged by the factor 100, so that each division on the time axis represents 1 µs. Regarding the gate-emitter voltage Vge, each division of the axis of ordinates represents 10V, for the collector-emitter voltage Vce each division of the axis of ordinates represents 250 V, and for the collector current Ic each division of the axis of ordinates represents 50 A.

As shown exemplarily in Fig. 1, a burst of high frequency switching signals Vge is applied to the gate of the IGBT for heating the IGBT. The frequency is for instance 300 kHz with an approximate 50 % duty cycle and the burst lasts for 350 µs. The collector-emitter voltage Vce is 700 V and the IGBT is connected to an inductive load with an inductivity of L=1.2 mH. The collector-emitter voltage Vce drops at the rising edge of the gate-emitter voltage Vge and has an over voltage peak at the falling edge of the gate-emitter voltage Vge. From Fig. 1 a it can be seen that the collector current experiences significant over current spikes at the rising edge of the gate-emitter voltage Vge and increases with each pulse of the gate-emitter voltage Vge. As can be derived from Fig. 1b, the current Ic reaches a plateau value of about 100 A at the end of the heating burst.

The switching energy that is caused by the transitions is defined as the integral of the collector current Ic multiplied by the collector-emitter voltage Vce. This switching energy heats up the semiconductor material fast and locally at the switch. It could be shown that a burst of Vge pulses lasting about 1 ms (as shown in Fig. 1a) causes the IGBT to heat up to approximately 125 °C (junction temperature). The power that is dissipated by the IGBT due to this switching operation is in a range of up to 10 kW. It has to be noted that by means of static losses such an amount of energy could not be provided because the necessary DC current would be much higher than the maximum allowed current.

When using the heating by a switching signal pulse train as shown in Fig. 1 for a serial final hot testing of the semiconductor components, the cycle time for the hot testing can be very short, e. g. only 2 to 3 ms.

It is clear for a person skilled in the art that all specific values given have to be understood as mere examples, other values are of course also encompassed by the present invention, as long as an alternating switching signal is used that leads to switching losses with enough energy for heating up the semiconductor switch.

According to the present invention, instead of a double pulse that is used in established RBSOA testing routines, a series of a predefined number of much shorter control voltage pulses Vge is applied to the IGBT. For instance, about 1000 pulses with duration of 1 to 1.5 µs are applied to cause the IGBT under test to be heated by its own switching losses. The testing environment does not have to be heated externally any more, but can stay unchanged apart from that modification.

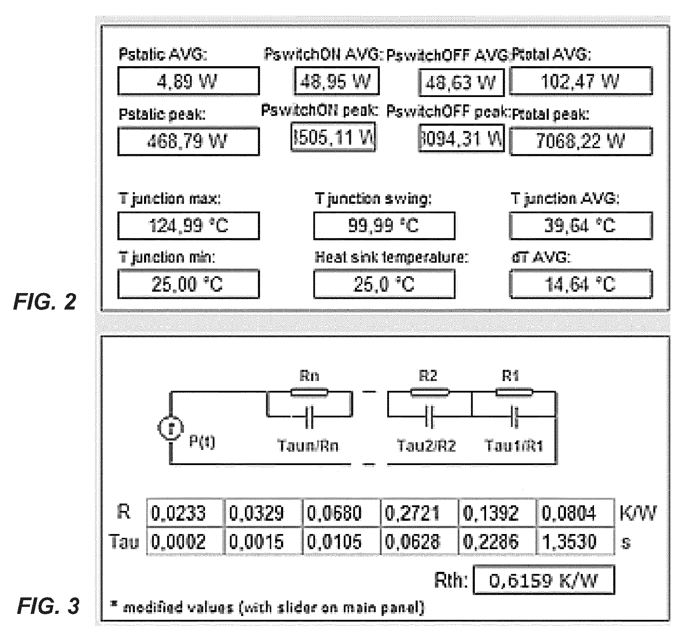

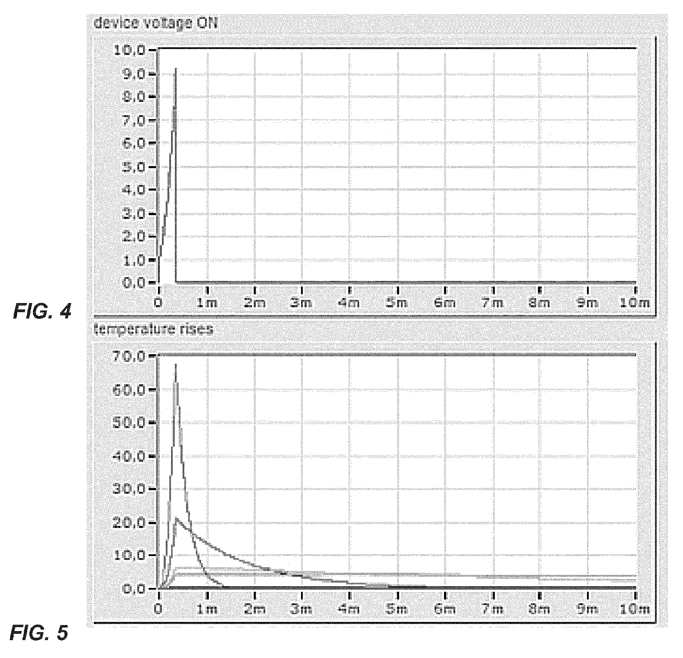

The number of pulses and the required repetition rate can be determined by means of a thermal simulation. Figures 2 to 7 illustrate exemplary simulation results for the thermal responses of an IGBT under the burst heating conditions shown in Fig. 1. As can be seen from Fig. 2, a peak value of the total power Ptotal of ca. 7 kW is reached, leading to a maximum junction temperature Tjunctionmax of about 125 °C.

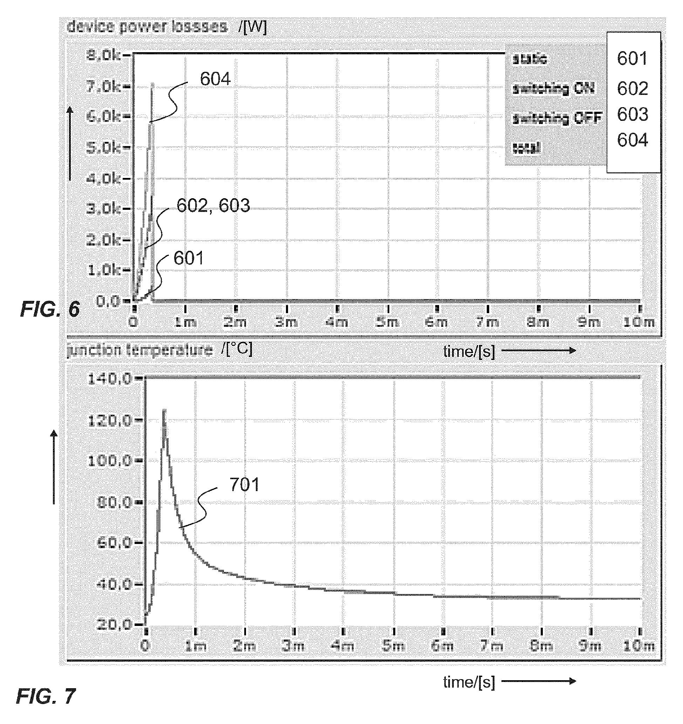

Fig. 6 shows the simulated power losses. In particular, rather low static losses (curve 601) are to be expected, whereas the switching losses for switching ON (curve 602) and switching OFF (curve 603) the IGBT cause the main part of the significant total power loss (curve 604) that leads to heating up the semiconductor switch.

Fig. 7 shows the simulated time diagram of the junction temperature (curve 701) achieved by the heating according to the present invention. A significant advantage of the present invention that can be recognized from this Figure is the fact that the maximum junction temperature is maintained only for a very short time. Because the substrate, housing, and further environment of the IGBT are not significantly heated, the IGBT starts cooling down immediately after the heating signal burst ends. This reduces the thermal stress on the semiconductor switch and saves time.

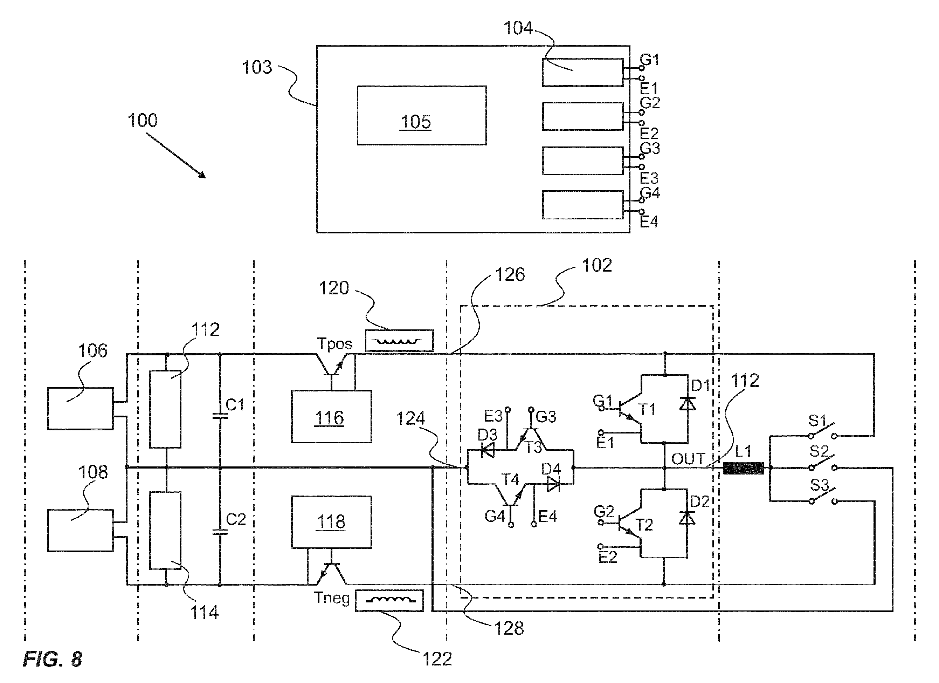

Figure 8 shows an exemplary testing system 100 for testing a power module 102 comprising four IGBT switches T1, T2, T3, T4 connected in a three-level T-type Neutral Point Clamped (NPC) architecture. Of course, any other architecture can be tested analogously. For providing control signals G1-G4 to each of the switches T1-T4, gate driver units 104 are provided. The testing system comprises a control unit 103 with a controller 105 that performs the controlling of the gate driver units 104.

For performing the testing procedure, a positive and a negative DC high voltage is applied to the power module 102 under test. The testing system 100 accordingly comprises a positive and a negative high voltage power supply 106, 108. In order to select the particular inductive load scenario, a load inductor L1 is coupled with a first end to a neutral output terminal 110 via a set of switches S1-S3. The control unit is further operable to control the switches S1-S3. Depending on the state of the switches S1-S3, the load inductor's second end can selectively be connected to the neutral input terminal 124 of the power module 102 or to the positive or negative input terminals 126, 128 of the power module 102.

For performing the test routine, the high voltage power supplies 106, 108 charge positive and negative capacitor banks C1, C2, respectively. A positive and a negative discharge circuit 112, 114 are coupled in parallel to the positive and negative capacitor banks C1, C2 for discharging the capacitor banks after testing or in case of any unexpected events. Moreover, a positive and a negative limiter circuit 116, 118 are provided to limit the current in response to a measured current monitored by a first and a second DC current sensor 120, 122.

When performing the test routine according to the present invention, each of the IGBTs T1 to T4 are sequentially connected to a forward biasing collector-emitter voltage Vce and is subjected to a 300 kHz heating pulse train as shown in Fig. 1 by the respective gate driver unit 104. For performing the testing of IGBTs T1, the switch S2 is closed, connecting the inductor L1 to the neutral input terminal 124 of the module under test. Switch S2 is also closed for testing the IGBT T2. Further, when testing IGBTs T3 and T4, respectively, either switch S1 or switch S3 are closed in order to connect the load inductor L1 either to the positive input terminal 126 or the negative input terminal 128 of the module under test 102, respectively.

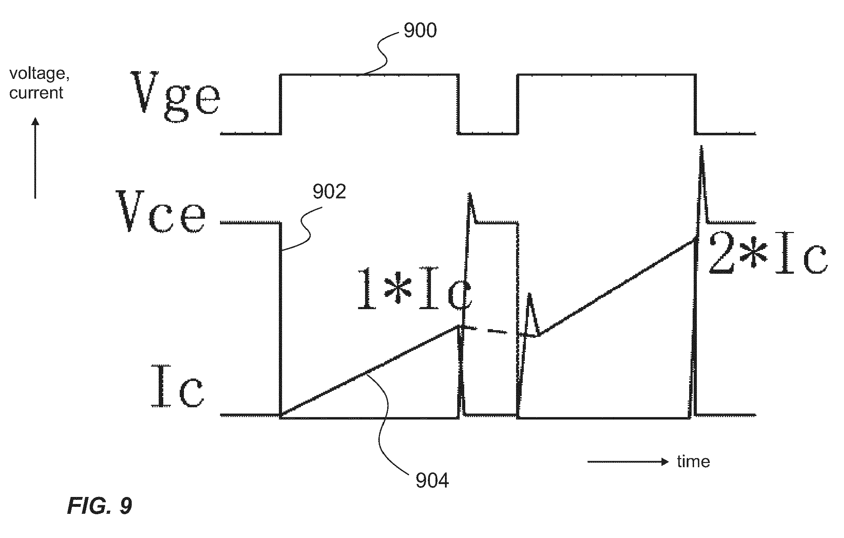

Figure 9 shows the waveforms of the collector-emitter voltage Vce (curve 902) and the collector current Ic (curve 904) in response to a double pulse of the controlling gate emitter voltage Vge (curve 900). Such a double pulse is usually applied to an IGBT under test in order to reach a final maximum collector current Ic that is approximately twice the nominal collector current Inom. With the testing method according to the present invention, the final collector current at the end of the heating step can analogously be adjusted to reach a predefined value, e. g. two times the nominal collector current Inom. This can be achieved by adjusting the ON and OFF time ratio, i. e. the duty cycle, of the respective IGBT under test so that the desired current is reached. Thus, the testing method can also be adapted to meet the specifications of established RBSOA testing routines.

In summary, the testing method according to the present invention allows heating only the chips in a power module without requiring additional equipment for the heating. The heating is fast and cost efficient. According to the present invention, the active heating can be merged into a conventional double pulse or RBSOA testing procedure. Of course, the idea of heating the semiconductor component by its own operation performed with high frequency can not only be used for testing active switches, but also for testing diodes, both with and without short circuit rating. Discrete semiconductors and complete circuit arrangements, such as power modules, with and without a baseplate can be tested regarding their dynamic parameters under elevated temperature by using the method according to the present invention.

## Claims

1. Testing method for testing at least one semiconductor component under elevated temperature conditions by means of a testing device, wherein the semiconductor component comprises at least one semiconductor switch and the method comprises the following steps:
electrically connecting the semiconductor component with the testing device,
supplying a heating signal from the testing device to the at least one semiconductor component, wherein supplying the heating signal comprises applying a switching signal to the semiconductor component that causes the semiconductor switch to open and close with a pre-determined switching frequency, so that the semiconductor component is at least partly heated up by switching losses caused by the semiconductor switch's switching operation,
supplying at least one test signal from the testing device to the at least one semiconductor component, and
in response to the at least one test signal, determining at least one test result of the semiconductor component.

2. Testing method according to one of the claims 1, wherein said at least one semiconductor switch comprises an Insulated Gate Bipolar Transistor (IGBT) and wherein said switching signal comprises a train of voltage pulses that is applied as a gate-emitter voltage (V_{ge}) to the IGBT.

3. Testing method of claim 1 or 2, wherein the switching signal comprises between 500 to 1000 pulses with a duration of 0.5 to 2 µs.

4. Testing method according to claim 2 or 3, wherein a collector-emitter voltage (V_{ce}) of the IGBT is in a range between 500 V and 900 V.

5. Testing method according to one of the preceding claims, wherein the heating signal is applied until a temperature of more than 100 °C is reached at the semiconductor component.

6. Testing method according to one of the preceding claims, further comprising the step of monitoring the temperature at the semiconductor component.

7. Testing method according to one of the preceding claims, wherein the step of determining at least one test result of the semiconductor component is performed while the semiconductor component is at elevated temperature.

8. Testing method according to one of the preceding claims, wherein at least one defined cooling step is performed after the step of heating up the semiconductor component.

9. Testing system for testing semiconductor components comprising at least one semiconductor switch under elevated temperature conditions, the system comprising:
a testing device that is electrically connected to the semiconductor component during the test,
a control means which is operable to supply a heating signal from the testing device to the at least one semiconductor component, wherein supplying the heating signal comprises applying a switching signal to the semiconductor component that causes the semiconductor switch to open and close with a pre-determined switching frequency, so that the semiconductor component is at least partly heated up by switching losses caused by the semiconductor switch's switching operation,
a measurement unit which is operable to supply at least one test signal from the testing device to the at least one semiconductor component and, in response to the at least one test signal, to determine at least one test result of the semiconductor component.

10. Testing system according to claim 9, comprising a high voltage power supply circuit that is coupled with an input connector for supplying an input power to the semiconductor component.

11. Testing system according to claim 9 or 10, wherein the testing system is operable to test at least one semiconductor switch being part of the semiconductor component, and wherein the testing system comprises at least one driver unit for driving the at least one semiconductor switch.

12. Testing system according to one of the claims 9 to 11, further comprising at least one current sensing unit for monitoring an input current that is applied to the semiconductor component, wherein the testing system further comprises a current limiter that is operable to limit the input current if the current sensing unit indicates that the input current exceeds a predefined threshold.

13. Testing system according to one of the claims 9 to 12, further comprising a switchable load inductor circuit that can selectively be connected to an output connector that can be coupled to output terminals of the semiconductor component.

14. Testing system according to one of the claims 9 to 13, the testing system being configured to test a three-level semiconductor component with a positive power input terminal, a negative power input terminal and a neutral power input terminal, and at least one output terminal, the testing system comprising:
a positive high voltage power supply unit for applying a positive DC voltage between the positive power input terminal and the neutral power input terminal, and a negative high voltage power supply unit for applying a negative DC voltage between the negative power input terminal and the neutral power input terminal,
a first capacitor being connected in parallel to the positive high voltage power supply unit, and a second capacitor being connected in parallel to the negative high voltage power supply unit, wherein a first discharge circuit is coupled in parallel to the first capacitor and a second discharge circuit is coupled in parallel to the second capacitor,
a load inductor that is selectively connected between the output terminal and either the positive power input terminal, the negative power input terminal or the neutral power input terminal,
at least one gate driver that is connectable to at least one gate of a semiconductor switch comprised in the semiconductor component, wherein said gate driver is operable to provide a switching signal to the semiconductor component that causes the semiconductor switch to open and close with a pre-determined switching frequency.

15. Testing system according to claim 14, further comprising:
a first current limiter that is connected in series between the positive high voltage power supply unit and the positive power input terminal for limiting a first input current flowing into the positive power input terminal in response to a first current sensor that is operable to monitor the first input current, and
a second current limiter that is connected in series between the negative high voltage power supply unit and the negative power input terminal for limiting a second input current flowing into the negative power input terminal in response to a second current sensor that is operable to monitor the second input current.
